# EUROPEAN PATENT SPECIFICATION

(11) **EP 0 298 625 B1**
(45) Date of publication and mention of the grant of the patent: **04.08.1993**
(21) Application number: 88305617.8
(22) Date of filing: 21.06.1988
(51) Int. Cl.: G01R 31/28, G06F 11/22, H04N 17/00

(54) **Method of and apparatus for establishing a servicing mode of an electronic apparatus**
Verfahren und Gerät zum Aufbauen eines Kundendienstmodus eines elektronischen Gerätes
Procédé et dispositif d'établissement d'un mode de service d'un appareil électronique

(30) Priority: 08.07.1987 JP 170307/87
(43) Date of publication of application: 11.01.1989
(73) Proprietor: SONY CORPORATION, Tokyo 141 (JP)
(72) Inventor: Suzuki, Masakazu, Shinagawa-ku, Tokyo 141 (JP); Suematsu, Masayuki, Shinagawa-ku, Tokyo 141 (JP); Komiya, Yoshinori, Shinagawa-ku, Tokyo 141 (JP)
(74) Representative: Thomas, Christopher Hugo

(56) References cited:
- EP-A- 0 136 060
- EP-A- 0 167 664
- US-A- 4 369 442
- US-A- 4 634 846

## Description

This invention relates to methods of and apparatuses for establishing a servicing mode of an electronic apparatus, and more particularly, but not exclusively, to such methods and apparatuses suitable for a colour television receiver of the inner-bus type in which the signal processing circuits are controlled by a microcomputer or central processing unit (CPU).

Video and audio apparatus such as television receivers, video tape recorders (VTRs) and audio tape recorders using digital signal processing circuits, have become commercially available. Most such digital apparatus uses inner (internal) buses for interconnecting a CPU, a memory, and other control circuitry. In a normal operating mode of the apparatus, the CPU fetches data corresponding to standardized control signal values for the several signal processing circuits of the apparatus, and which have been previously stored in the memory. The CPU sends the fetched data to the appropriate circuit by way of the inner buses, so as suitably to control the operation of the respective signal processing circuit. Further, the CPU may control the signal processing circuits in response to signals supplied thereto by manual actuation of a keyboard or a remote controller, thereby permitting the changing, at will, of the conditions of the signal processing circuits. The provision of a television receiver with an inner-bus system has the advantage of permitting standardized, centralized and simplified testing of the circuitry of the receiver during assembling and servicing thereof, thereby substantially reducing the manufacturing and maintenance costs. Such a television receiver is disclosed in our U.S. patent specification US-A-4 701 870.

In the case of an inner-bus television receiver, the data stored in the memory in correspondence with predetermined conditions of the adjustable circuits, for example, for establishing standardized values of contrast, hue and balance of a displayed colour image, may be rewritten or changed to data corresponding to other values or predetermined conditions when testing the operation of the television receiver at the time of manufacture, or when the television receiver is undergoing maintenance or servicing and it is found necessary to adjust such characteristics of the displayed image due to secular changes that have occurred in components of the receiver. To rewrite or change the data stored in the memory, it is necessary to establish a servicing mode of the television receiver. For this purpose, known television receivers of the inner-bus type have been provided with a change-over switch which is manually actuable for changing from the ordinary operating mode to the servicing mode. However, when such a switch is provided, there is the risk that the user may inadvertently actuate the switch and thereby establish the servicing mode of the television receiver, in which mode, the stored data for establishing the standardized conditions of the displayed colour image may be disturbed.

To avoid this problem, an inner-bus television receiver may be arranged so that, when electric power is supplied to the receiver, establishment of the servicing mode thereof requires that a plurality of switches, such as the switches associated with the channel selection keys or push-buttons, need to be actuated in a predetermined order. Although the foregoing arrangement reduces the chances of inadvertently establishing the servicing mode, it is nevertheless still possible that the keys or push-buttons may, by chance, be actuated in the predetermined order. EP-A-0 167 664 discloses a similar arrangement where it is suggested that several keys be pressed simultaneously in order to place the television receiver into the service mode. This disclosure accords with the preambles of claims 1 to 6.

According to the present invention there is provided a method of controlling an electronic apparatus comprising a plurality of circuits which are individually adjustable in accordance with respective control signals, non-volatile memory means for storing data corresponding to predetermined conditions of said adjustable circuits, respectively, a central processing unit to receive said data from said memory means and to provide said control signals to said adjustable circuits in corresponding with said data, a main power supply source for supplying electric power to said adjustable circuits, a stand-by power supply source for supplying electric power to said central processing unit, key input means selectively operable to provide input data to said central processing unit, and inner bus means for connecting said central processing unit to said adjustable circuits, said memory means and said key input means;
wherein:
said memory means also stores a secret code; and
said input data provided by said key input means can represent an externally applied code and, in a servicing mode of the apparatus, data for re-writing in said memory means said data corresponding to predetermined conditions of said adjustable circuits;
characterised in that:
said method comprises the steps of:
turning on said stand-by power supply source;
operating said key input means for inputting data representing said externally applied code to said central processing unit;
turning on said main power supply source for supplying power to said adjustable circuits; and
establishing said servicing mode of the apparatus only when said externally applied code coincides with said secret code stored in said memory means and said turning on of the main power supply source is effected within a predetermined period after said externally applied code provided by operation of said key input means is made to be coincident with said secret code.

According to the present invention there is also provided an electronic apparatus comprising a plurality of circuits which are individually adjustable in accordance with respective control signals, non-volatile memory means for storing a secret code and for storing data corresponding to predetermined conditions of said adjustable circuits, respectively, a central processing unit to receive said data read from said memory means and to provide said control signals to said adjustable circuits in correspondence with said read data, main power supply means for supplying electric power to said adjustable circuits, stand-by power supply means for supplying electric power to said central processing unit, key input means selectively operable to provide input data to said central processing unit, and inner bus means for connecting said central processing unit to said adjustable circuits, said memory means and said key input means;
wherein:
said input data can represent an externally applied code and, in a servicing mode of the apparatus, data for re-writing in said memory means said data corresponding to predetermined conditions of said adjustable circuits;
characterised by:
means for establishing said servicing mode of the apparatus only when said externally applied code coincides with said secret code stored in said memory means and said main power supply means is turned on within a predetermined period after said externally applied code is made to be coincident with said secret code.

The invention will now be described by way of example with reference to the accompanying drawings, throughout which like parts are referred to by like references, and in which:
Figure 1 is a block diagram of a television receiver of the type to which the present invention can be applied.
Figure 2 is a diagrammatic elevational view showing the arrangement of keys or push-buttons on the panel of a remote controller used with the television receiver of Figure 1; and
Figure 3 is a flow chart for establishing the servicing mode.

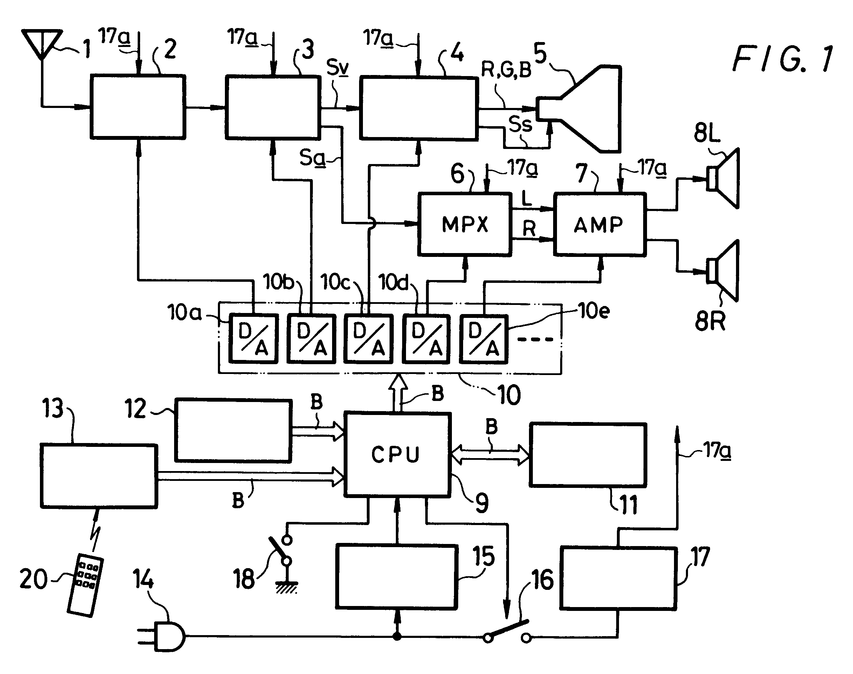

A method and apparatus for establishing a servicing mode of an electronic apparatus will now be described with reference to an inner-bus type colour television receiver. As shown in Figure 1, the receiver includes an antenna 1 from which a received broadcast signal is supplied to a tuner 2 which extracts an intermediate frequency signal and supplies it to an intermediate frequency amplifier 3. A video signal Sv is supplied from an output terminal of the amplifier 3 to a video processing circuit 4 which derives colour signals R, G and B, and horizontal and vertical synchronizing signals Ss which are supplied to a colour cathode ray tube 5.

The amplifier 3 further provides, at another output terminal thereof, an audio signal Sa which is supplied to a multiplexer 6 in which it is separated into a left-channel audio signal L and right-channel audio signal R which are supplied through an audio amplifier 7 to a left channel loudspeaker 8L and a right-channel loudspeaker 8R, respectively. Thus, in normal operation, a colour image corresponding to the video portion of a broadcoast television signal is displayed by the tube 5, while the left and right-channel audio signals are reproduced by the loudspeakers 8L and 8R, respectively.

The operations of the tuner 2, the amplifier 3, the video processing circuit 4, the multiplexer 6 and the audio amplifier 7, are adjustably controlled by respective control signals provided by a CPU 9 through a digital-to-analogue (D/A) converter unit 10. More particularly, the CPU 9 is connected to the circuits 2 to 4, 6 and 7 through D/A converters 10a, 10b, 10c, 10d and 10e, respectively, of the converter unit 10, and which supply analogue control signals to the respective adjustable circuits in response to the reception of digital signals or data from the CPU 9 by way of an inner bus B.

The CPU 9 is also connected through the bus B to a non-volatile memory 11 which stores data corresponding to predetermined conditions of the adjustable circuits, and also stores a secret number or code for avoiding inadvertent establishment of the servicing mode of the receiver. The data corresponding to the predetermined conditions of the adjustable circuits may, for example, correspond to control signals selected to achieve standardized contrast, hue and balance of a displayed colour image.

The CPU 9 is further connected through the bus B to a keyboard 12 having keys or push-buttons that are manually actuable for controlling or changing, at will, corresponding control signals supplied by the CPU 9 to the circuits 2 to 4, 6 and 7, and the like. An infrared light signal receiver 13 is connected to the CPU 9 by way of the bus B and is operative, in response to the reception of infrared signals from a remote control signal transmitter (controller) 20, to provide data to the CPU 9 similar to that obtained when the keyboard 12 is actuated. The CPU 9 is also operative to control the change-over of the operating mode of the receiver between a normal operating mode and servicing mode.

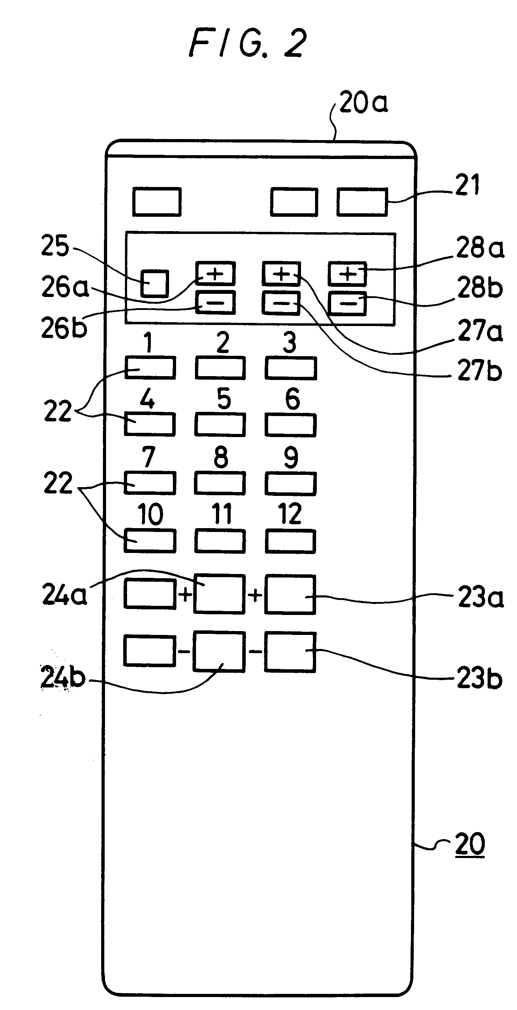

The television receiver further includes a stand-by power supply circuit 15 to be continuously connected to a commercial AC electric power source through a plug 14 so as continuously to supply electric power to the CPU 9, and a main power supply circuit 17 which is connected to the plug 14 through contacts of a relay 16 controlled by the CPU 9, so that the commercial source is connected to the main supply circuit 17 for energizing it only when the contacts of the relay 16 are closed. The main supply circuit 17 is connected, as at 17a, to each of the circuits to be powered thereby, for example, the circuits 2 to 4, 6 and 7, so that an image is displayed and sound is produced only when the contacts of the relay 16 are closed. The CPU 9 closes the contacts of the relay 16 in response to the manual actuation of a power supply switch 18 connected to thy CPU 9, and which is provided on the television receiver, or in response to manual actuation of a power supply key 21 on the remote controller 20 (see also Figure 2).

The remote controller 20 has on one end an infrared light signal emitting device 20a from which a suitable modulated infrared beam is directed to the infrared receiver 13, thereby to transmit control signals in accordance with the manual actuation of operation controlling keys or push-buttons of the remote controller 20. More specifically, the remote controller 20 has, in addition to the power supply key 21, a channel-selecting key pad 22 comprising keys or push-buttons for selecting respective numbered channels, channel up/down keys 23a and 23b actuable for increasing and decreasing, respectively, the number of the channel selected to be received, volume adjusting keys 24a and 24b for increasing and decreasing, respectively, the volume of the sound from the loudspeakers 8L and 8R, a standard setting key 25, contrast adjusting keys 26a and 26b, hue adjusting keys 27a and 27b, and balance adjusting keys 28a and 28b. In response to actuation of any of these keys, a correspondingly modulated infrared light signal is emitted from the device 20a for controlling a corresponding function of the television receiver.

More specifically, selective actuation of the contrast adjusting keys 26a and 26b, hue adjusting keys 27a and 27b or balance adjusting keys 28a and 28b is effective to change the contrast, hue or colour phase, or balance of the displayed image. On the other hand, in response to actuation of the standard setting key 25, the contrast, hue and balance of the displayed image are automatically set to respective intermediate or standardized values which are predetermined and stored in the memory 11, thereby to adjust simultaneously the several characteristics to a standardized condition. Data corresponding to predetermined conditions of the adjustable circuits for establishing the standardized values are written into the memory 11 during manufacture of the television receiver, and particularly, during the final adjustment or alignment of the circuits. Moreover, the data written in the memory 11 and corresponding to the predetermined conditions of the adjustable circuits can be rewritten in the course of the maintenance or servicing of the television receiver, and may compensate for secular or relatively long term changes in the component parts of the television receiver, for example, in the tube 5. To effect such rewriting of the data stored in the memory 11, it is necessary to effect the change-over of the television receiver from the its normal operating mode to a servicing mode.

Such change-over will now be described. Initially, the television receiver has a secret number of code suitably stored in the memory 11. For example, this may consist of the numerals "4, 3, 2, 1" in that order. Generally, the television receiver having the secret number or code stored in its memory 11 initially receives only stand-by power supplied to the CPU 9 from the stand-by supply circuit 15, while the contacts of the relay 16 remain open, with the result that the main supply circuit 17 is off. With the television receiver only receiving stand-by power, the operator actuates a plurality of the channel selecting keys of the keyboard 12 or of the key 22 in the order corresponding to that of the code stored in the memory 11. The resulting externally applied code causes corresponding data to be applied to the CPU 9 either from the keyboard 12 or from the infrared receiver 13, and the CPU 9 compares such externally applied code with the secret number or code previously stored in the memory 11 and detects if and when the externally applied code is coincident with it.

After supplying the code, the user actuates the power supply switch 18, or the power supply key 21, and the CPU 9 responds by energizing the relay 16, thereby making the main supply circuit 17 operative. The CPU 9 is operative to establish the servicing mode of the television receiver only when the main supply circuit 17 is made operative within a predetermined period, for example, one minute, after the external application of a code which coincides with the secret number or code stored in the memory 11.

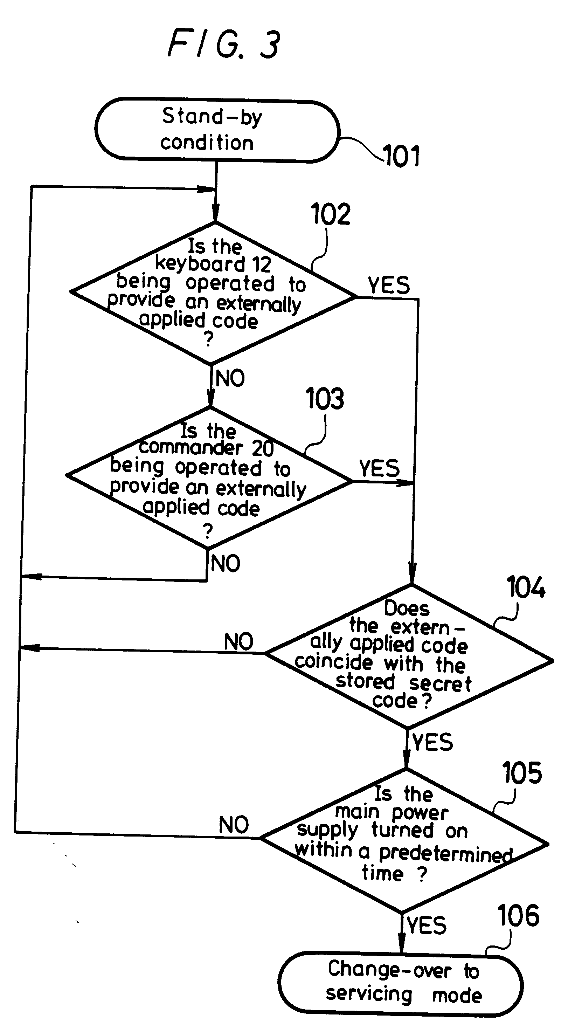

As shown in Figure 3, the program for changing-over the television receiver from its normal operating mode to its servicing mode starts, in step 101, with the television receiver in its stand-by condition, that is, with only the stand-by supply circuit 15 operative to supply electric power to the CPU 9, and with the relay 16 de-energized. In the stand-by condition, it is detected in the step 102 whether or not the channel selecting keys of the keyboard 12 are being operated to provide an externally applied code. If an externally applied code is not detected in step 102, the program proceeds to the step 103 in which it is detected whether or not the channel selecting keys of the remote controller 20 are being operated to provide an externally applied code. If a externally applied code is not detected in the step 103, the program returns to the start thereof. However, if an externally applied code is detected in either the step 102 or the step 103, the program proceeds to the step 104 in which it is detected whether or not the externally applied code coincides with the secret code stored in the memory 11. If it does not, the program is returned to the start thereof. However, if it does, the program proceeds to the step 105 in which it is detected whether or not the main supply circuit 17 is on, as by actuation of the power supply key 21, within a predetermined period of time, for example, one minute, after the code coincidence. If the main supply circuit 17 is not turned on within the predetermined period, the program returns to the start thereof. However, if the main supply circuit 17 is turned on within the predetermined period, the program proceeds to the step 106 in which the television receiver is changed-over to its servicing mode. Inadvertent change-over of the television receiver to its servicing mode is securely prevented.

On the other hand, when the externally applied code resulting from actuation of the keyboard 12 or the remote controller 20 coincides with the secret code stored in the memory 11 and the main supply circuit 17 is turned on within the predetermined time after such coincidence, the television receiver is reliably changed-over to its servicing mode in which the operativeness of the main supply circuit 17 causes the television receiver to display a colour image corresponding to the broadcast or other video signal supplied.

The establishment of the servicing mode of the television receiver by the CPU 9 allows rewriting of the standardized intermediate values for the contrast, hue and balance of the image, which are stored in the memory 11. Such rewriting is effected by actuating the respective keys on the remote controller 20. More specifically, with the television receiver in its servicing mode, the stored standard value of the contrast, hue or balance, is rewritten by suitably operating the contrast adjusting keys 26a and 26b, the hue adjusting keys 27a and 27b, or the balance adjusting keys 28a and 28b. During such rewriting, the colour image is displayed on the tube 5, so that it can be monitored to determine how the rewriting of the stored standard values affects the appearance thereof.

After the adjustment has been completed, the power supply switch 18 or key 21 is again actuated to cause the CPU 9 to open the contacts of the relay 16 and thereby turn off the main supply circuit 17. The CPU 9 then returns the television receiver from its servicing mode to its ordinary operating mode, with the rewritten or adjusted standardized values stored in the memory 11.

If the power supply switch 18 or key 21 is actuated to cause the CPU 9 to turn on the main supply circuit 17 more than the predetermined period of time, for example, one minute, after the channel selection keys have been actuated to provide an externally applied code that coincides with the stored code, or if the main power supply circuit 17 is turned on without first actuating the channel selection keys to provide an externally applied code, the television receiver is made operative in its normal operating mode. With the television receiver in its normal operating mode, actuation of any of the keys of the remote controller 20 will merely effect the normal selective control. Moreover, with the television receiver in its normal operating mode, actuation of the standard setting key 25 causes the CPU 9 to read the standardized values for the contrast, hue ad balance then stored in the memory 11, and to supply corresponding control signals through the converter unit 10 to the circuits 2, 3 and 4, with the result that the displayed image then exhibits the standardized values of contrast, hue and balance.

It will be appreciated that, the actuation of the key pad 22 or the keyboard 12 for providing an externally applied code coinciding with the stored code is effected at a time when the CPU 9 is supplied only with the stand-by power from the stand-by supply circuit 15. Thus, even if the keys are accidentally actuated in correspondence with the stored secret code at a time when the television receiver is being supplied with power from the main supply circuit 17, that is, in normal use, change-over to the servicing mode cannot occur by inadvertence, and, accordingly, the standardized values stored in the memory 11 cannot be disturbed. Furthermore, since the channel selection keys of the keyboard 12 or of the remote controller 20 are used for effecting change-over from the normal operating mode to the servicing mode, there is no need to provide an additional operating key, so the construction and control of the television receiver are simplified. Nevertheless, the stored standardized values can be readily adjusted or rewritten so as to compensate for secular changes, that is, changes occurring over a long period of time, for example, due to aging, of the television receiver.

In the illustrated embodiment, the stand-by supply circuit 15 is shown to be continuously connected to a commercial AC power source. However, a battery, capacitor or the like may be provided as a back-up or secondary source of power for the stand-by supply circuit 15. Moreover, although the invention has been described as applied to an inner-bus television receiver, it can be similarly applied to other electronic apparatus, such as VTRs.

## Claims

1. A method of controlling an electronic apparatus comprising a plurality of circuits (2 to 4, 6, 7) which are individually adjustable in accordance with respective control signals, non-volatile memory means (11) for storing data corresponding to predetermined conditions of said adjustable circuits (2 to 4, 6, 7), respectively, a central processing unit (9) to receive said data from said memory means (11) and to provide said control signals to said adjustable circuits (2 to 4, 6, 7) in corresponding with said data, a main power supply source (17) for supplying electric power to said adjustable circuits (2 to 4, 6, 7), a stand-by power supply source (15) for supplying electric power to said central processing unit (9), key input means (12, 22) selectively operable to provide input data to said central processing unit (9), and inner bus means (13) for connecting said central processing unit (9) to said adjustable circuits (2 to 4, 6, 7), said memory means (11) and said key input means (12, 22);
wherein:
said memory means (11) also stores a secret code; and
said input data provided by said key input means (12, 22) can represent an externally applied code and, in a servicing mode of the apparatus, data for re-writing in said memory means (11) said data corresponding to predetermined conditions of said adjustable circuits (2 to 4, 6, 7);
characterised in that:
said method comprises the steps of:
turning on said stand-by power supply source (15);
operating said key input means (12, 22) for inputting data representing said externally applied code to said central processing unit (9);
turning on said main power supply source (17) for supplying power to said adjustable circuits (2 to 4, 6, 7); and
establishing said servicing mode of the apparatus only when said externally applied code coincides with said secret code stored in said memory means (11) and said turning on of the main power supply source (17) is effected within a predetermined period after said externally applied code provided by operation of said key input means (12, 22) is made to be coincident with said secret code.

2. A method according to claim 1 wherein said electronic apparatus is a colour television receiver.

3. A method according to claim 2 wherein when said servicing mode is established, said key input means (12, 22) is operated for said rewriting of data in said memory means (11) so as to compensate for changed conditions of at least one of said adjustable circuits (2 to 4, 6, 7).

4. A method according to claim 3 wherein said rewriting of data changes at least one of the contrast, hue and balance of a colour image provided by said colour television receiver.

5. A method according to any one of the preceding claims wherein said key input means (12, 22) includes a remote commander (20).

6. A electronic apparatus comprising a plurality of circuits (2 to 4, 6, 7) which are individually adjustable in accordance with respective control signals, non-volatile memory means (11) for storing a secret code and for storing data corresponding to predetermined conditions of said adjustable circuits (2 to 4, 6, 7), respectively, a central processing unit (9) to receive said data read from said memory means (11) and to provide said control signals to said adjustable circuits (2 to 4, 6, 7) in correspondence with said read data, main power supply means (17) for supplying electric power to said adjustable circuits (2 to 4, 6, 7), stand-by power supply means (15) for supplying electric power to said central processing unit (9), key input means (12, 22) selectively operable to provide input data to said central processing unit (9), and inner bus means (13) for connecting said central processing unit (9) to said adjustable circuits (2 to 4, 6, 7), said memory means (11) and said key input means (12, 22);
wherein:
said input data can represent an externally applied code and, in a servicing mode of the apparatus, data for re-writing in said memory means (11) said data corresponding to predetermined conditions of said adjustable circuits (2 to 4, 6, 7);
characterised by:
means (9) for establishing said servicing mode of the apparatus only when said externally applied code coincides with said secret code stored in said memory means (11) and said main power supply means (17) is turned on within a predetermined period after said externally applied code is made to be coincident with said secret code.

7. An electronic apparatus according to claim 6 whereby said apparatus is a colour television receiver and said plurality of circuits (2 to 4, 6, 7) which are individually adjustable in accordance with respective control signals are adjustable for varying at least one of the contrast, hue and balance of a colour image displayed by the receiver.

8. A television receiver according to claim 7 wherein said key input means (12, 22) includes first keys (22) operable for channel selection and for generating said externally applied code, and second keys (26 to 28) operable, in said servicing mode, for said rewriting of the data stored in said memory means (11) and, in a normal operating mode of the television receiver, for changing at will at least said one of the contrast, hue and balance of the displayed colour image.

9. A television receiver according to claim 8 wherein said key input means (12, 22) further includes a standard setting key (25) operable in said normal operating mode to cause reading out of the data stored in said memory means (11) for correspondingly standardizing at least said one of the contrast, hue and balance of the displayed colour image.

10. A television receiver according to claim 9 wherein said key input means (12, 22) is included in a remote controller (20).

## Patentansprüche

1. Verfahren zur Steuerung eines elektronischen Geräts
mit einer Mehrzahl von Schaltungen (2 bis 4, 6, 7), die in Abhängigkeit von entsprechenden Steuersignalen individuell einstellbar sind,
mit einer nichtflüchtigen Speichereinrichtung (11) Zur Speicherung von Daten, die vorbestimmten Zuständen der jeweiligen einstellbaren Schaltungen (2 bis 4, 6, 7) entsprechen,
mit einer zentralen Prozessoreinheit (9) zur Aufnahme der genannten Daten aus der Speichereinrichtung (11) und zur Abgabe der genannten Steuersignale an die einstellbaren Schaltungen (2 bis 4, 6, 7) nach Maßgabe der genannten Daten,
mit einer Haupt-Versorgungsquelle (17) für die Stromversorgung der einstellbaren Schaltungen (2 bis 4, 6, 7),
mit einer Bereitschafts-Versorgungsquelle (15) für die Stromversorgung der zentralen Prozessoreinheit (9),
mit Tasten-Eingabemitteln (12, 22), die zur Lieferung von Eingangsdaten an die zentrale Prozessoreinheit (9) selektiv betätigbar sind,
sowie mit einem internen Bus (13) für die Verbindung der zentralen Prozessoreinheit (9) mit den einstellbaren Schaltungen (2 bis 4, 6, 7), der Speichereinrichtung (11) und der Tasten-Eingabemitteln (12, 22), wobei
die Speichereinrichtung (11) außerdem einen Geheimkode speichert und
die von den Tasten-Eingabemitteln (12, 22) gelieferten Eingangsdaten einen extern angelegten Kode und - in einem Wartungsmodus des Geräts - Daten für das Neueinschreiben der vorbestimmten Zustände der einstellbaren Schaltungen (2 bis 4, 6, 7) entsprechenden Daten in die Speichereinrichtung (11) repräsentieren können,
**gekennzeichnet** durch die Verfahrensschritte:
Einschalten der Bereitschafts-Versorgungsquelle (15),
Betätigen der Tasten-Eingabemittel (12, 22) zur Eingabe von den extern genannten angelegten Kode repräsentierenden Daten in die zentrale Prozesoreinheit (9),
Einschalten der Haupt-Versorgungsquelle (17) für die Stromversorgung der einstellbaren Schaltungen (2 bis 4, 6, 7) und
Einrichten des genannten Wartungsmodus des Geräts nur dann, wenn der extern angelegte Kode mit dem in der Speichereinrichtung (11) gespeicherten Geheimkode übereinstimmt und das Einschalten der Haupt-Versorgungsquelle (17) innerhalb einer vorbestimten Zeitspanne erfolgt, nachdem der durch die Betätigung der Tasten-Eingabemittel (12, 22) gelieferte extern angelegte Kode in Übereinstimmung mit dem Geheimkode gebracht ist.

2. Verfahren nach Anspruch 1, bei dem das elektronische Gerät ein Farbfernsehempfänger ist.

3. Verfahren nach Anspruch 2, beidem dann, wenn der Wartungsmodus eingerichtet ist, die Tasten-Eingabemittel (12, 22) für das Neueinschrieben von Daten in die Speichereinrichtung (11) so betätigt werden, daß geänderte Zustände wenigstens einer der einstellbaren Schaltungen (2 bis 4, 6, 7) kompensiert werden.

4. Verfahren nach Anspruch 3, bei dem durch das Neueinschreiben von Daten wenigstens eines der Merkmale Kontrast, Farbton und Balance eines von dem Farbfernsehempfänger erzeugten Farbbildes verändert wird.

5. Verfahren nach einem der vorhergehenden Ansprüche, bei dem die Tasten-Eingabemittel (12, 22) eine Fernsteuerung (20) umfassen.

6. Elektronisches Gerät mit mit einer Mehrzahl von Schaltungen (2 bis 4, 6, 7), die in Abhängigkeit von entsprechenden Steuersignalen individuell einstellbar sind, mit einer nichtflüchtigen Speichereinrichtung (11) zum Speichern eines Geheimkodes und zum Speichern von Daten, die vorbestimmten Zuständen der jeweiligen einstellbaren Schaltungen (2 bis 4, 6, 7) entsprechen, mit einer zentralen Prozessoreinheit (9) zur Aufnahme der genannten aus der Speichereinrichtung (11) ausgelesen Daten und zur Abgabe der genannten Steuersignale an die einstellbaren Schaltungen (2 bis 4, 6, 7) nach Maßgabe der genannten Daten, mit einer Haupt-Versorgungsquelle (17) für die Stromversorgung der einstellbaren Schaltungen (2 bis 4, 6, 7), mit einer Bereitschafts-Versorgungsquelle (15) für die Stromversorgung der zentralen Prozessoreinheit (9), mit Tasten-Eingabemitteln (12, 22), die zur Lieferung von Eingangsdaten an die zentrale Prozessoreinheit (9) selektiv betätigbar sind, sowie mit einem internen Bus (13) für die Verbindung der zentralen Prozessoreinheit (9) mit den einstellbaren Schaltungen (2 bis 4, 6, 7), der Speichereinrichtung (11) und der Tasten-Eingabemitteln (12, 22), wobei
die Eingangsdaten einen extern angelegten Kode repräsentieren können und - in einem Wartungsmodus des Geräts - Daten für das Neueinschreiben der vorbestimmten Zustände der einstellbaren Schaltungen (2 bis 4, 6, 7) entsprechenden Daten in die Speichereinrichtung (11),
**gekennzeichnet** durch
Mittel (9) zum Einrichten des Wartungsmodus des Gerät nur dann, wenn der extern angelegte Kode mit dem in der Speichereinrichtung (11) gespeicherten Geheimkode übereinstimmt und die Haupt-Versorgungsquelle (17) innerhalb einer vorbestimmen Zeitspanne eingeschaltet wird, nachdem der extern angelegte Kode mit dem Geheimkode in Übereinstimmung gebracht wurde.

7. Elektronisches Gerät nach Anspruch 6, wobei das Gerät ein Farbfernsehempfänger ist und die Mehrzahl von Schaltungen (2 bis 4, 6, 7), die in Abhängigkeit von entsprechenden Steuersignalen einstellbar sind, zur Änderung wenigstens eines der Merkmale Kontrast, Farbton und Balance eines von dem Farbfernsehempfänger wiedergegebenen Farbbildes eingestellt werden.

8. Farbfernsehempfänger nach Anspruch 7, bei dem die Tasten-Eingabemittel (12, 22) erste Tasten (20) für die Kanalwahl und für die Erzeugung des extern angelegten Kodes aufweist sowie zweite Tasten (26 bis 28), die in dem Wartungsmodus für das Neueinschreiben der in der Speichereinrichtung (11) gespeicherten Daten und im normalen Betriebsmodus des Farbfernsehempfängers zur beliebigen Änderung wenigstens eines der Merkmale Kontrast, Farbton und Balance des wiedergegebenen Farbbildes betätigbar sind.

9. Farbfernsehempfänger nach Anspruch 8, bei dem die Tasten-Eingabemittel (12, 22) weiterhin eine Standard-Einstelltaste (25) aufweisen, die in dem normalen Betriebsmodus betätigbar ist, um ein Auslesen der in der Speichereinrichtung (11) gespeicherten Daten zu veranlassen, um wenigstens eines der Merkmale Kontrast, Farbton und Balance des wiedergegebenen Farbbildes zu standardisieren.

10. Farbfernsehempfänger nach Anspruch 9, bei dem die Tasten-Eingabemittel (12, 22) in einer Fernsteuerung (20) enthalten sind.

## Revendications

1. Procédé pour commander un appareil électronique comprenant une pluralité de circuits (2 à 4, 5, 6) qui sont réglables individuellement selon des signaux de commande respectifs, un dispositif à mémoire non-volatile (11) pour stocker des données correspondant respectivement aux conditions prédéterminées desdits circuits réglables (2 à 4, 6, 7), une unité centrale de traitement (9) pour recevoir lesdites données dudit dispositif à mémoire (11) et pour fournir lesdits signaux de commande auxdits circuits réglables (2 à 4, 6, 7) en correspondance avec lesdites données, une source principale d'alimentation d'énergie (17) pour l'alimentation électrique desdits circuits réglables (2 à 4, 6, 7), une source de secours d'alimentation d'énergie (15) pour fournir l'énergie électrique à l'unité centrale de traitement (9), un dispositif d'entrée à touches (12, 22) pouvant fonctionner sélectivement pour fournir des données d'entrée à ladite unité centrale de traitement (9), et un dispositif de bus interne (13) pour relier ladite unité centrale de traitement (9) auxdits circuits réglables (2 à 4, 6, 7), audit dispositif à mémoire (11) et audit dispositif d'entrée à touches (12, 22); dans lequel:
ledit dispositif à mémoire (11) stocke aussi un code secret; et lesdites données d'entrée fournies par ledit dispositif d'entrée à touches (12, 22) peuvent représenter un code appliqué de façon externe et, dans un mode de maintenance de l'appareil, des données pour réécrire dans ledit dispositif à mémoire (11) lesdites données correspondantes aux conditions prédéterminées desdits circuits réglables (2 à 4, 6, 7);
caractérisé en ce que:
ledit procédé comprend les étapes de:
la mise en marche de ladite source de secours d'énergie d'alimentation d'énergie (15);
le fonctionnement dudit dispositif d'entrée à touches (12, 22) pour introduire des données représentant ledit code appliqué de façon externe à ladite unité centrale de traitement (9);
la mise en marche de ladite source principale d'alimentation (9) pour fournir l'énergie auxdits circuits réglables (2 à 4, 6, 7); et
l'établissement dudit mode de maintenance de l'appareil seulement lorsque ledit code appliqué de façon externe coïncide avec ledit code secret stocké dans ledit dispositif à mémoire (11) et lorsque ladite mise en marche de la source principale d'alimentation d'énergie (17) est effectuée dans une période prédéterminée après que ledit code appliqué de façon externe fourni par l'utilisation dudit dispositif d'entrée à touches (12, 22) coïncide avec ledit code secret.

2. Procédé selon la revendication 1 dans lequel ledit appareil électronique est un récepteur de télévision couleur.

3. Procédé selon la revendication 2 dans lequel lorsque ledit mode de maintenance est établi, ledit dispositif d'entrée à touches (12, 22) est utilisé pour effectuer ladite réécriture des données dans ledit dispositif à mémoire (11) afin de compenser des conditions ayant changé au moins un desdits circuits réglables (2 à 4, 6, 7).

4. Procédé selon la revendication 3 dans lequel ladite réécriture de données change au moins un des réglages de contraste, de couleur et de balance d'une image couleur fournie par ledit récepteur de télévision couleur.

5. Procédé selon l'une quelconque des revendications précédentes dans lequel ledit dispositif d'entrée à touches (12, 22) comprend une télécommande (20).

6. Appareil électronique comprenant une pluralité de circuits (2 à 4, 6, 7) qui sont réglables individuellement selon des signaux de commande respectifs, un dispositif à mémoire non-volatile (11) pour stocker un code secret et pour stocker des données correspondant aux conditions prédéterminées desdits circuits réglables (2 à 4, 6, 7), respectivement, une unité centrale de traitement (9) pour recevoir lesdites données lues dans ledit dispositif à mémoire (11) et pour fournir lesdits signaux de commande auxdits circuits réglables (2 à 4, 6, 7) en correspondance avec lesdites données lues, un dispositif principal d'alimentation d'énergie (17) pour fournir l'énergie électrique auxdits circuits réglables (2 à 4, 6, 7), un dispositif de secours d'alimentation d'énergie (15) pour fournir l'énergie électrique à ladite unité centrale (9), un dispositif d'entrée à touches (12, 22) qui peut fonctionner sélectivement pour fournir des données d'entrée à ladite unité centrale de traitement (9), et un dispositif de bus interne (13) pour relier ladite unité centrale (9) auxdits circuits réglables (2 à 4, 6, 7), audit dispositif à mémoire (11) et audit dispositif d'entrée à touches (12,22); dans lequel:
lesdites données d'entrée peuvent représenter un code appliqué de façon externe et, dans un mode de maintenance de l'appareil, des données pour réécrire dans ledit dispositif à mémoire (11) lesdites données correspondant aux conditions prédéterminées desdits circuits réglables (2 à 4, 6, 7);
caractérisé par:
un dispositif (9) pour établir ledit mode de maintenance de l'appareil seulement lorsque ledit code appliqué de façon externe coïncide avec ledit code secret stocké dans ledit dispositif à mémoire (11) et lorsque ledit dispositif principal d'alimentation d'énergie (17) est mis en marche dans une période prédéterminée après que le code appliqué de façon externe coïncide audit code secret.

7. Appareil électronique selon la revendication 6 dans lequel ledit appareil est un récepteur de télévision couleur et ladite pluralité de circuits (2 à 4, 6, 7) qui sont réglables individuellement selon des signaux de commande, sont réglables pour faire varier au moins un des réglages de contraste, de couleur, et de balance d'une image couleur affichée par le récepteur.

8. Récepteur de télévision selon la revendication 7 dans lequel ledit dispositif d'entrée à touches (12, 22) comprend des premières touches (22) utilisables pour sélectionner le canal et pour générer ledit code appliqué externe, et des secondes touches (26 à 28) utilisables dans ledit mode de maintenance, pour ladite réécriture de données stockées dans ledit dispositif à mémoire (11) et, dans un mode de fonctionnement normal du récepteur de télévision, pour changer à volonté, au moins un des réglages de contraste, de couleur, de balance de l'image couleur affichée.

9. Récepteur de télévision selon la revendication 8 dans lequel ledit dispositif d'entrée à touches (12, 22) comprend en outre une touche de réglage standard (25) utilisable dans le mode de fonctionnement normal pour provoquer la lecture des données stockées dans ledit dispositif à mémoire (11) pour standardiser également au moins un desdits réglages de contraste, de couleur, et de balance de l'image couleur affichée.

10. Récepteur de télévision selon la revendication 9 dans lequel ledit dispositif d'entrée à touches (12, 22) est inclus dans une télécommande (20).
